# EUROPÄISCHE PATENTSCHRIFT

(11) **EP 2 095 478 B1**
(45) Veröffentlichungstag und Bekanntmachung des Hinweises auf die Patenterteilung: **16.02.2011**
(21) Anmeldenummer: 07802008.8
(22) Anmeldetag: 30.08.2007
(51) Int. Cl.: H02G 3/14

(54) **GEHÄUSE**
HOUSING
BOÎTIER

(30) Priorität: 08.11.2006 DE 102006052723
(43) Veröffentlichungstag der Anmeldung: 02.09.2009
(73) Patentinhaber: Cooper Crouse-Hinds GmbH, 59494 Soest (DE)
(72) Erfinder: NAUMANN, Reiner, 68239 MAnnheim (DE); SCHWARZ, Gerhard, 69436 Schönbrunn (DE); HOFMANN, Gert, 69412 Eberbach (DE)
(74) Vertreter: Grünecker, Kinkeldey, Stockmair & Schwanhäusser Anwaltssozietät
(86) Internationale Anmeldenummer: PCT/EP2007/007589
(87) Internationale Veröffentlichungsnummer: WO 2008/055557

(56) Entgegenhaltungen:
- CH-A- 470 598
- DE-U1- 9 216 735
- FR-A- 2 099 120
- US-A- 6 032 420

## Beschreibung

Die Erfindung betrifft ein Gehäuse, insbesondere ein explosionsgeschütztes Gehäuse, mit wenigstens einem eine Gehäusewandung aufweisenden Gehäuseunterteil, welches eine durch eine Klappe verschließbare Gehäuseöffnung aufweist, wobei die Klappe mittels einer Gelenkeinrichtung zwischen einer Öffnungs- und einer Schließstellung verschwenkbar gelagert ist.

Solche Gehäuse dienen beispielsweise zum Einbau von Klemmen von eigensicheren und nicht eigensicheren Stromkreisen. Die Gehäuse sind explosionsgeschützt in der Schutzart Ex-e beziehungsweise Ex-i ausgebildet. Materialien für solche Gehäuse sind beispielsweise Metall, insbesondere rostfreier Stahl, oder Kunststoff, insbesondere Polyester oder glasfaserverstärkter Polyester.

Aus der Praxis sind im Wesentlichen zwei unterschiedliche Arten solcher Gehäuse bekannt. Bei einer ersten Gehäuseart ist eine entsprechende Gelenkeinrichtung zum Verschwenken einer Klappe zwischen Öffnungs- und Schließstellung relativ zu einer Gehäuseöffnung des Gehäuses auf einer Außenseite der Gehäusewandung angeordnet. Dadurch ist es nicht möglich, zwei Gehäuse im Bereich dieser Gelenkeinrichtung so nahe beieinander anzuordnen, dass die Gehäusewandungen in Kontakt sind. Zwar ist bei dieser Art der Gelenkeinrichtung der gesamte Innenraum des Gehäuses zur Installation entsprechender elektrischer und elektronischer Einrichtungen nutzbar, aber die Anordnung einer solchen externen Gelenkeinrichtung erfordert zumindest einen bestimmten Abstand zwischen benachbarten Gehäusen.

Eine zweite Gehäuseart weist im Innenraum angeordnete Gelenkeinrichtungen auf, so dass diese Gehäuse zumindest eng benachbart und unter Anlage der entsprechenden Gehäusewandungen nebeneinander anordbar sind. Allerdings ist durch die Anordnung der Gelenkeinrichtung im Gehäuseinneren der Raum zur Anordnung von elektrischen und elektronischen Einrichtungen vermindert.

Der Erfindung liegt die Aufgabe zugrunde, ein Gehäuse der eingangs genannten Art dahingehend zu verbessern, dass sowohl eine eng benachbarte Anordnung von Gehäusen als auch die vollständige Nutzung des Gehäuseinneren möglich ist.

Diese Aufgabe wird durch die Merkmale des Patentanspruchs 1 gelöst.

Erfindungsgemäß erfolgt weder eine externe noch interne Anordnung der Gelenkeinrichtung. Stattdessen weist die Gelenkeinrichtung ein direkt in der Gehäusewandung angeordnetes Gelenkunterteil und ein an einer der Gehäuseöffnung in Schließstellung zuweisenden Klappenunterseite der Klappe angeordnetes Gelenkoberteil auf. Gelenkunterteil und Gelenkoberteil sind verschwenkbar miteinander verbunden.

Durch die Anordnung des Gelenkunterteils innerhalb der Gehäusewandung ist es weder notwendig, einen bestimmten Abstand bei Nebeneinanderanordnung von zwei Gehäusen oder mehreren Gehäusen einzuhalten, noch wird durch diese Anordnung das Gehäuseinnere in irgendeiner Weise verkleinert. Die Gehäusewandung ist bei solchen Gehäusen bereits mit ausreichender Wandstärke ausgebildet, da beispielsweise zur Fixierung der Klappe in Schließstellung Schraubbolzen von oben durch die Klappe bis in die Gehäusewandung eingeschraubt werden können.

Um das Gelenkunterteil in einfacher Weise auszubilden und gleichzeitig in der Gehäusewandung aufnehmen zu können, kann das Gelenkunterteil als Gelenkstange ausgebildet sein, welche zumindest teilweise in eine Aufnahmebohrung in der Gehäusewandung eingesteckt ist. Eine solche Gelenkstange kann unterschiedliche Querschnitte aufweisen, wobei einfache Querschnitte, wie kreisförmig, viereckig oder dergleichen bevorzugt werden.

Bei nicht runden Querschnitten ergibt sich als weiterer Vorteil, dass die Gelenkstange in einer Aufnahmebohrung mit entsprechendem Querschnitt im Wesentlichen drehfest angeordnet ist.

Die Gelenkstange ist in diesem Zusammenhang in entsprechender Weise mit dem Gelenkoberteil verschwenkbar verbunden.

Um ein Öffnen der Klappe auch bei eng nebeneinander angeordneten Gehäusen in einfacher Weise zu ermöglichen, kann das Gelenkunterteil in der Aufnahmebohrung in Bohrungslängsrichtung verschiebbar angeordnet sein. Dadurch ist das Gelenkunterteil bei Öffnen der Klappe aus der Aufnahmebohrung herausziehbar, so dass die Klappe in Öffnungsstellung auch im Bereich der Gelenkeinrichtung in einem größerem Abstand zum Gehäuseunterteil angeordnet werden kann und dadurch auch leichter relativ zu den angrenzenden Gehäusen verschwenkbar ist.

Eine einfache Möglichkeit zur Verbindung von Gelenkstange und Gelenkoberteil kann darin gesehen werden, wenn die Gelenkstange an ihrem aus der Aufnahmebohrung vorstehenden Gelenkende mit dem Gelenkoberteil verschwenkbar verbunden ist. Eine entsprechende Schwenkverbindung kann als Lageröse am Gelenkende der Lenkstange und als Ösenaufnahmeschlitz am Gelenkoberteil ausgebildet sein.

Insbesondere hinsichtlich des Explosionsschutzes ist es von Vorteil, wenn die Klappe in Schließstellung so nah wie möglich am Gehäuseunterteil angeordnet ist. Dies ist beispielsweise dadurch in einfacher Weise erreichbar, dass die Gelenkstange in Schließstellung zusammen mit dem Gelenkoberteil im Wesentlichen innerhalb der Gelenkbohrung in Rückzugstellung angeordnet sind. Der Querschnitt des Gelenkoberteils ist in diesem Zusammenhang passend zum Querschnitt der Aufnahmebohrung ausgebildet, so dass in Schließstellung der Klappe das Gelenkoberteil so weit wie möglich ebenfalls innerhalb der Aufnahmebohrung angeordnet ist.

Um bei Anordnung der Klappe in Schließstellung die Gelenkstange einfacher innerhalb der Aufnahmebohrung anordnen zu können und gleichfalls bei Öffnen der Schließstellung gegen eine entsprechende Kraft die Klappe öffnen zu können, kann die Gelenkstange in Richtung Rückzugstellung kraftbeaufschlagt sein.

Eine Möglichkeit zur Kraftbeaufschlagung ist beispielsweise eine teleskopierbare Gelenkstange, die in ihrem Inneren eine entsprechende Rückstellungseinrichtung aufweist. Eine weitere Möglichkeit zu einer solchen Kraftbeaufschlagung ist ein Federelement. Dieses kann in unterschiedlicher Weise angeordnet sein. Im einfachsten Fall wirkt es zwischen Gelenkstange und Gehäusewandung, wobei das Federelement an oder auf der Gelenkstange angeordnet und zwischen dieser und einem Teil der Aufnahmebohrung befestigt sein kann.

Das entsprechende Federelement kann in diesem Zusammenhang als Schraubenfeder ausgebildet sein. Je nach Anordnung des Federelements relativ zu Gelenkstange und Aufnahmebohrung ist die Schraubenfeder eine Schraubenzug- oder Schraubendruckfeder. Bei einer Schraubendruckfeder wird diese bei Öffnen der Klappe durch Verschieben der Gelenkstange aus der Aufnahmebohrung heraus komprimiert, so dass durch die Feder ein Druck auf die Gelenkstange in Schließstellung der Klappe ausgeübt wird. Bei einer Schraubenzugfeder wird diese bei Verschieben der Gelenkstange bei Öffnen der Klappe gedehnt, und sie übt einen Zug auf die Gelenkstange in Richtung Schließstellung der Klappe aus.

Um auch in einfacher Weise nachträglich und je nach Erfordernis die Klappe des Gehäuses mittels der Gelenkeinrichtung am Gehäuse anzubringen, kann die Aufnahmebohrung zumindest eine im Wesentlichen quer zur Bohrungslängsrichtung zur Außenseite der Gehäusewandung offene Ausnehmung aufweisen. Die entsprechende Gelenkstange ist zusammen mit der Klappe oder dem Deckel vom offenen Ende der Aufnahmebohrung her einsetzbar. Die Gelenkstange ist dann so weit in der Aufnahmebohrung verschiebbar, bis ein entsprechendes unteres Ende der Gelenkstange in der offenen Ausnehmung angeordnet ist. Hier kann dann von der Außenseite der Gehäusewandung her insbesondere das Federelement eingesetzt werden und damit die Gelenkstange innerhalb der Aufnahmebohrung lösbar befestigt werden.

Dies erfolgt in umgekehrter Weise bei einer Demontage der Klappe oder bei einer anderen Anordnung der Klappe relativ zum Gehäuseunterteil, um beispielsweise eine andere Aufklapprichtung und eine andere Anordnung der Gelenkeinrichtung hinsichtlich des Gehäuseunterteils zu erreichen.

Um beispielsweise das Gehäuse an einer Wand oder dergleichen befestigen zu können, kann die Aufnahmebohrung zur Aufnahme von Schraubbolzen ausgebildet sein. Auch diese sind mittels der entsprechenden Ausnehmung handhabbar und insbesondere zum Verschrauben zugänglich.

In der Regel sind zwei Aufnahmebohrungen und zwei Gelenkstangen zum sicheren Lagern und Verschwenken der Klappe relativ zum Gehäuseunterteil ausreichend. Um aber beispielsweise Aufnahmebohrungen für Schraubbolzen zusätzlich zur Anordnung der Gelenkeinrichtungen nutzen zu können oder um gegebenenfalls mehr Variationen zur verschwenkbaren Lagerung der Klappe zur Verfügung zu haben, kann eine Anzahl von Aufnahmebohrungen in Umfangsrichtung des Gehäuses in der Gehäusewandung verteilt sein. In der Regel werden zwei dieser Aufnahmebohrungen für die Gelenkeinrichtung verwendet, während die übrigen Aufnahmebohrungen ungenutzt oder zum Einschrauben von Schraubbolzen nutzbar sind.

Im Wesentlichen kann das Gehäuse beliebige Querschnitte aufweisen. Zur eng benachbarten Anordnung von mehreren Gehäusen sind allerdings in der Regel eckige Querschnitte von Vorteil, wie beispielsweise ein viereckiger Querschnitt aus zwei Längsseiten und zwei Querseiten. Ist der Querschnitt quadratisch, so können entlang aller vier Seiten entsprechende weitere Gehäuse mit entsprechenden Abmessungen in direkter Nachbarschaft angeordnet werden. Dies gilt analog auch für rechteckige, fünfeckige oder sechseckige Querschnitte.

Bei solchen eckigen Querschnitten ist es von Vorteil, wenn die entsprechenden Aufnahmebohrungen im Wesentlichen entlang von Verbindungskanten der Seiten in der Gehäusewand ausgebildet sind.

Die entsprechenden Schraubbolzen können ebenfalls verwendet werden, um ein Gehäuseunterteil aus mehreren Einzelteilen zusammenzusetzen. In diesem Zusammenhang müssen die Schraubbolzen nicht zusätzlich zur Befestigung des Gehäuses an einer Wand oder dergleichen eingesetzt werden.

Um gegebenenfalls auch die Klappe in Schließstellung mit dem Gehäuseunterteil verschrauben zu können, kann die Klappenunterseite Klappenbohrungen im Wesentlichen in Verteilung und Abmessung passend zu zumindest einigen Aufnahmebohrungen aufweisen. Diese Klappenbohrungen können auch als Einsteckvertiefungen ausgebildet sein, die nicht bis auf die Klappenoberseite durchgeführt sind.

Sind die Klappenbohrungen allerdings bis auf die Klappenoberseite durchgeführt, können sie im Wesentlichen die Aufnahmebohrungen im Bereich der Klappe fortsetzen.

Es besteht die Möglichkeit, Aufnahmebohrungen separat für die Gelenkstangen und separat für die Schraubbolzen anzuordnen. Dabei ist es von Vorteil wenn die Aufnahmebohrungen für die Gelenkstangen benachbart zu Aufnahmebohrungen für Schraubbolzen angeordnet sind und beide gemeinsame Ausnehmungen aufweisen. In der Regel sind bei beispielsweise viereckigen Querschnitten für ein Gehäuse vier Aufnahmebohrungen entlang von Kanten des Gehäuses für Gelenkstangen ausreichend. Diese vier Aufnahmebohrungen erlauben eine verschwenkbare Lagerung der Klappe entlang jeder Seite und damit eine vorteilhafte Variation der Öffnungsrichtung und Anlenkung der Klappe relativ zum Gehäuseunterteil.

Sind die oben genannten Klappenbohrungen nur als Einsteckvertiefungen ausgebildet, können sie vorteilhafterweise zur Anordnung von Einsteckstutzen an der Klappenunterseite verwendet werden, die entlang einer Seite gegenüberliegend zu den Gelenkoberteilen angeordnet sind. Diese Einsteckstutzen greifen in obere Öffnungen von entsprechenden Aufnahmebohrungen in Schließstellung der Klappe ein, wodurch die Schließstellung besser definiert und ebenfalls die Abdichtung zwischen Klappe und Gehäuseunterteil verbessert ist.

Eine einfache Anordnung des Federelements beim Zusammenbau von Klappe und Gehäuseunterteil ergibt sich insbesondere dann, wenn das Federelement mit einem Ende an einem Aufnahmezwischenboden zwischen zwei in Bohrungslängsrichtung hintereinander ausgebildeten Ausnehmungen befestigt ist.

Es besteht ebenfalls die Möglichkeit, dass die Aufnahmebohrung sich durch den Aufnahmezwischenboden erstreckt. In diesem Fall kann das entsprechende Ende des Federelements auch in der im Aufnahmezwischenboden ausgebildeten Aufnahmebohrung befestigt werden.

Um ebenfalls ein einfaches Befestigen des Federelements an der Gelenkstange im Bereich der Ausnehmung zu ermöglichen, kann das Federelement an einem unteren freien, in der Aufnahmebohrung angeordneten Ende der Gelenkstange insbesondere lösbar befestigt sein.

Um sowohl die Gehäuseeinzelteile zur Bildung des Gehäuseunterteils als auch die Schließstellung ausreichend insbesondere im Hinblick auf den Explosionsschutz abdichten zu können, können zwischen den Gehäuseeinzelteilen des Gehäuseunterteils beziehungsweise zwischen Gehäuseunterteil und Klappe Dichtelemente, insbesondere Silikondichtungen angeordnet sein.

Ein solches Gehäuse kann, wie bereits ausgeführt, beispielsweise mittels der Schraubbolzen an einer Wand oder dergleichen befestigt werden. Es sind ebenfalls zusätzliche Einrichtungen auf der Außenseite des Gehäuses denkbar, die beispielsweise eine Wand-, Gitterrinnen- oder Rohrbefestigung erlauben.

Um die Klappe sowohl beim Öffnen als auch Schließen besser handhaben zu können, kann die Klappe auf ihrer Oberseite Griffmulden und/oder Griffrillen aufweisen.

Werden die Aufnahmebohrungen zur Anordnung von Schraubbolzen und damit beispielsweise zur Fixierung der Klappe am Gehäuseunterteil in Schließstellung verwendet, kann es weiterhin günstig sein, wenn die Aufnahme-/Klappenbohrungen des Gehäuseunterteils beziehungsweise der Klappe an ihrem jeweils zur Klappe beziehungsweise zum Gehäuseunterteil entfernten Ende eine Versenkungsvertiefung aufweisen. In dieser ist der Schraubbolzen so weit einschraubbar, dass er nicht über die Kontur des Gehäuseunterteils beziehungsweise der Klappe vorsteht.

Es besteht die Möglichkeit, das erfindungsgemäße Gehäuse jeweils separat an entsprechenden Einrichtungen wie zum Beispiel Schalt- und Verteileranlagen an entsprechenden Steckplätzen oder dergleichen zu befestigten. Durch die bei den erfindungsgemäßen Gehäusen enge Anordnung von benachbarten Gehäusen können diese allerdings auch zusätzlich miteinander direkt verbunden werden.

Im Folgenden wird ein vorteilhaftes Ausführungsbeispiels der Erfindung anhand der in der Zeichnung beigefügten Figuren näher erläutert und beschrieben.

Es zeigen:
- Figur 1: eine perspektivische Ansicht schräg von oben auf zwei nebeneinander angeordnete erfindungsgemäße Gehäuse;
- Figur 2: eine Vergrößerung eines Details "X" aus Figur 1 ;
- Figur 3: eine Vergrößerung eines Details "Y" aus Figur 1 mit Klappe in Öffnungsstellung;
- Figur 4: eine perspektivische Ansicht von schräg vorne auf ein Gehäuse mit Klappe in Öffnungsstellung, und
- Figur 5: eine perspektivische Ansicht auf zwei nebeneinander angeordnete erfindungsgemäße Gehäuse mit Klappe eines Gehäuses in Öffnungsstellung.

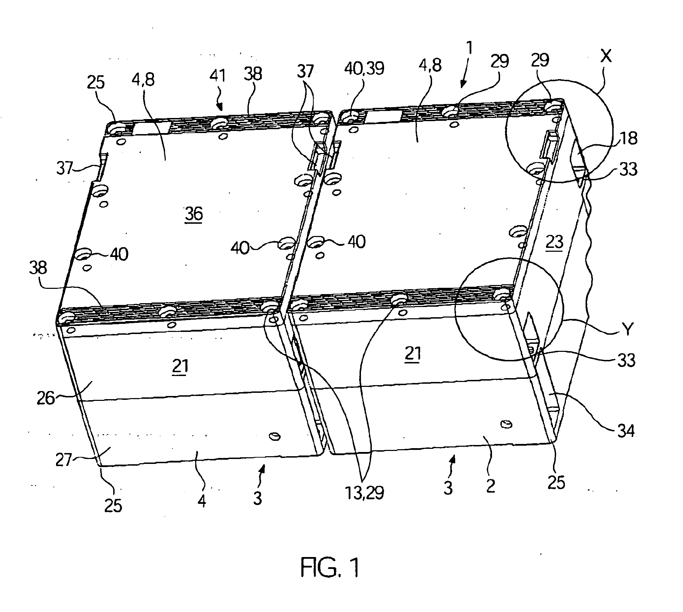

Figur 1 zeigt eine perspektivische Ansicht von schräg oben und vorne auf zwei nebeneinander angeordnete Gehäuse 1 und 41. Jedes dieser Gehäuse weist ein Gehäuseunterteil 3 und eine verschwenkbar an diesem gelagerte Klappe 4 auf. Die Klappe 4 ist über eine Gelenkeinrichtung 6, siehe auch die folgenden Figuren, zwischen einer Offnungsstellung 7 und der in Figur 1 dargestellten Schließstellung 8 verschwenkbar gelagert.

Auf einer Oberseite 36 einer jeden Klappe 4 sind eine Reihe von Aufnahmebohrungen 13, 29 sichtbar, die entlang entsprechender Verbindungskanten 25 von Längs- beziehungsweise Querseiten 21, 23 der Gehäuse 1 beziehungsweise 41 im Bereich des Gehäuseunterteils 3 ausgebildet sind. Auf der entsprechenden Oberseite 36 sind die Aufnahmebohrungen 29 von einer Versenkungsvertiefung 40 am jeweils zum anderen Teil, das heißt Klappe beziehungsweise Gehäuseunterteil entfernten Ende 39 umgeben. Diese Versenkungsvertiefung 40 dient zum Einschrauben entsprechender Schraubbolzen 19, siehe die folgenden Figuren, so dass diese versenkt angeordnet sind und nicht über die entsprechende Kontur von Klappe 4 beziehungsweise Gehäuse 1 oder 41 vorstehen. Weiterhin sind an der Klappe 4 zwei gegenüberliegende Griffmulden 37 sowie entlang von Längsseiten 21 beziehungsweise 22 verlaufende Griffrillen 38 angeordnet. Die Längsseite 22 liegt der Längsseite 21 in Figur 1 gegenüber und ist in den folgenden Figuren näher beschrieben. In analoger Weise sind Querseiten 23 und 24 einander gegenüberliegend angeordnet, siehe hierzu auch die folgenden Figuren.

Das einteilige Gehäuseunterteil 3 weist obere und untere Gehäusehälften 26 und 27 auf. Bei einzelnen Gehäusehälften könnten diese mittels entsprechender Schraubbolzen 19 druckfest und entsprechend zum jeweiligen Explosionsschutz miteinander verbunden sind. Dieselben oder weitere Schraubbolzen 19 sind ebenfalls zur Fixierung der Klappe 4 in Schließstellung 8 einsetzbar.

Benachbart zu entsprechenden Verbindungskanten 25, siehe beispielsweise Querseite 23 des Gehäuses 1, sind zur Außenseite 42 des Gehäuses 1 offene Ausnehmungen 18 und 34 übereinander angeordnet. Diese sind durch einen Aufnahmezwischenboden 33 voneinander getrennt. Durch den Aufnahmezwischenboden 33 erstreckt sich die Aufnahmebohrung 13, siehe die folgenden Figuren, wobei sich ebenfalls die entsprechende Aufnahmebohrung 29 durch diesen Aufnahmezwischenboden 33 bis zur Unterseite des Gehäuseunterteils 3 erstrecken kann.

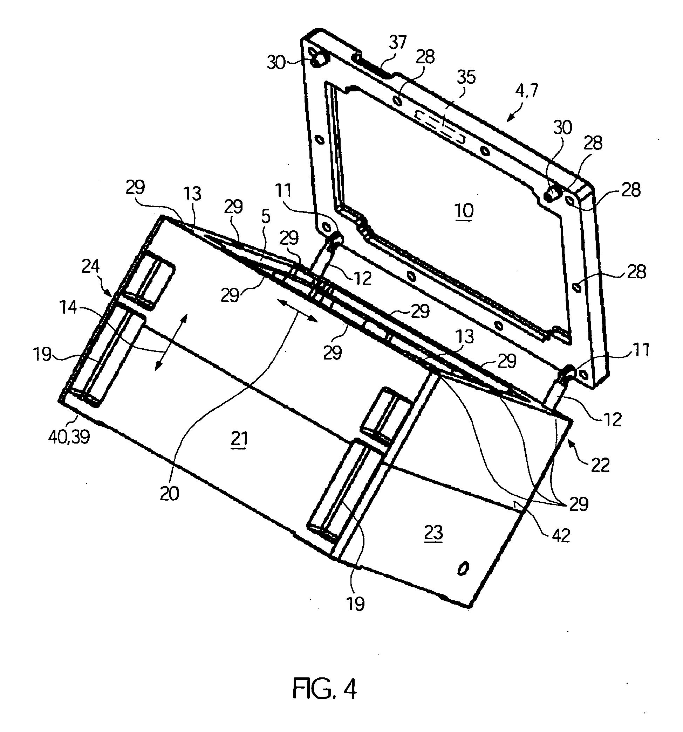

Insgesamt bilden die Längs- und Querseiten eine Gehäusewandung 2 die um das Gehäuse 1 in Umfangsrichtung 20, siehe beispielsweise Figur 4, umläuft.

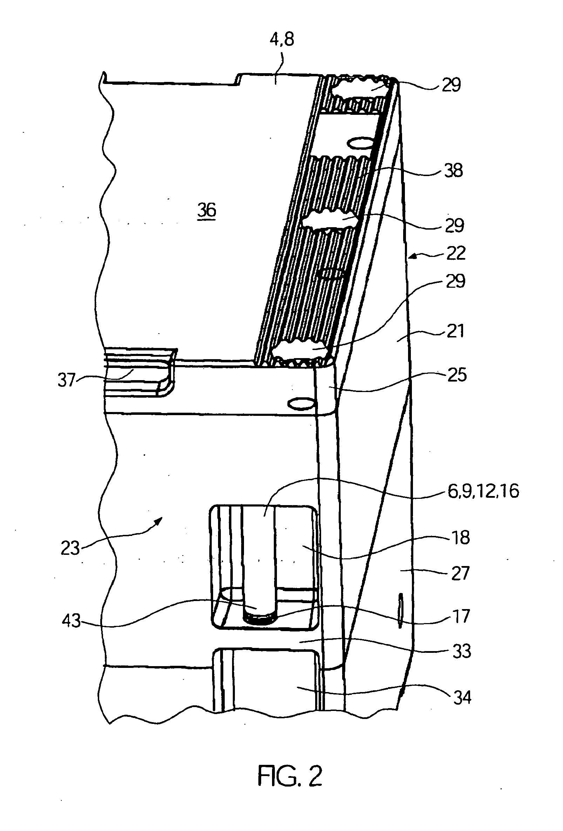

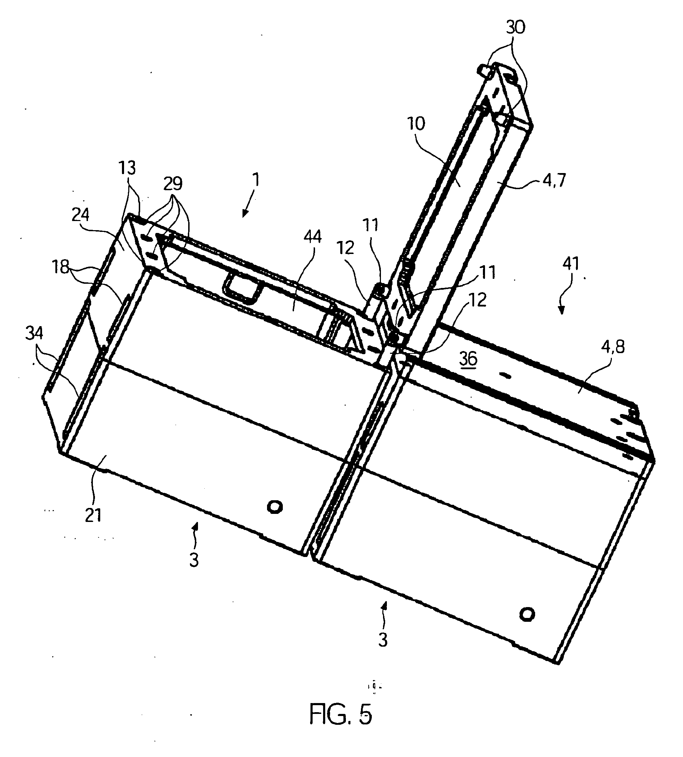

Figur 2 entspricht einer vergrößerten Darstellung des Details "X" aus Figur 1. Innerhalb der oberen Ausnehmung 18, siehe auch Figur 1, ist in Figur 2 als Teil der Gelenkeinrichtung 6 ein Gelenkunterteil 9 sichtbar, das als Gelenkstange 12 ausgebildet und in einer Rückzugsstellung 16 angeordnet ist. In dieser Rückzugsstellung 16 ist es im Wesentlichen vollständig in der entsprechenden Aufnahmebohrung 13, siehe auch Figuren 4 und 5, angeordnet. Zwischen einem unteren Ende 43 der Gelenkstange 12 und dem Aufnahmezwischenboden 33 ist zur Kraftbeaufschlagung der Gelenkstange 12 in Richtung Rückzugsstellung 16 ein Federelement 17 angeordnet. Die Gelenkstange 12 ist innerhalb der Gehäusewandung 2 beziehungsweise der Querseite 23 angeordnet, so dass erfindungsgemäß keine externe oder interne Gelenkeinrichtung 6, sondern eine innerhalb der Gehäusewandung 2 angeordnete Gelenkeinrichtung 6 verwendet wird.

Die obere Ausnehmung 18 dient insbesondere zur Montage der Gelenkeinrichtung 6, das heißt der Gelenkstange 12 mit Federelement 17 und zur Befestigung des Federelements 17 zwischen unterem Ende 43 der Gelenkstange 12 und Aufnahmezwischenboden 33.

Zur Vereinfachung ist in Figur 2 kein entsprechender Schraubbolzen 19 dargestellt, der sich durch Aufnahmebohrung 29 erstrecken kann und ebenfalls in Ausnehmung 18 beziehungsweise Ausnehmung 34 sichtbar wäre.

Eine Reihe der entsprechenden Aufnahmebohrungen 29 ist entlang der Umfangsrichtung 20 verteilt, siehe auch Figur 1, wobei sich entsprechend die in der Klappe 4 dargestellten Bohrungen 29 bis in das Gehäuseunterteil 3 und gegebenenfalls auch bis zum unteren Ende des Gehäuseunterteils 3 fortsetzen.

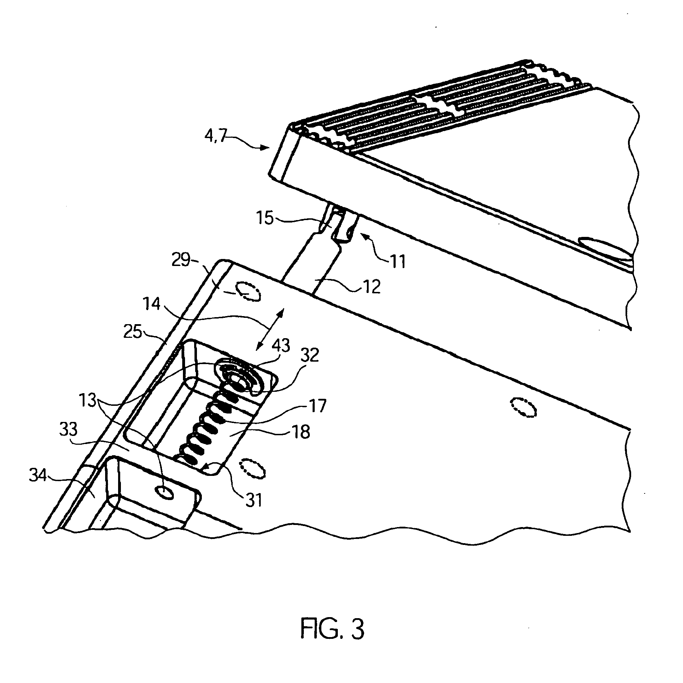

In Figur 3 ist ein Detail "Y" aus Figur 1 vergrößert dargestellt, wobei hier allerdings die Klappe 4 in Öffnungsstellung 7 angeordnet ist. In dieser Figur wie in allen übrigen Figuren sind gleiche Teile jeweils durch gleiche Bezugszeichen gekennzeichnet und werden teilweise nur in Zusammenhang mit einer Figur näher erläutert.

In Öffnungsstellung 7 der Klappe 4 ist die Gelenkstange 12 aus der Rückzugsstellung 16 nach Figur 2 herausbewegt und in Bohrungslängsrichtung 14 insbesondere in Richtung Klappe 4 verschoben. Eine entsprechende Rückstellungskraft in Richtung Rückzugsstellung 6 wird durch Federelement 17 ausgeübt, welches in Figur 3 zwischen Aufnahmezwischenboden 33 und unterem Ende 43 der Gelenkstange 12 gespannt ist. Das Federelement 17 ist mit seinem unteren Ende 31 am Aufnahmezwischenboden 33 und mit seinem oberen Ende 12 am unteren Ende 43 der Gelenkstange 12 befestigt.

Neben der Aufnahmebohrung 13 ist in Figur 3 noch gestrichelt die Aufnahmebohrung 29 zur Anordnung eines entsprechenden Schraubbolzens 19, siehe auch Figur 4, angeordnet. Diese kann sich analog entlang der entsprechenden Verbindungskante 25 und ebenfalls durch Ausnehmungen 18 und 34 erstrecken.

Die Gelenkstange 12 ist mit ihrem Gelenkende 15, das in Form einer Verbindungsöse ausgebildet ist mit einem Gelenkoberteil 11 der Gelenkeinrichtung 6 verbunden. Dieses Gelenkoberteil 11 weist eine schlitzförmige Ösenaufnahme auf, in der das Gelenkende 15 eingesteckt und dort verschwenkbar gelagert ist.

Es sei an dieser Stelle noch darauf hingewiesen, dass ebenfalls die Möglichkeit besteht, dass das Federelement 17 die Gelenkstange 12 in die Stellung nach Figur 3 kraftbeaufschlagt, so dass das entsprechende Federelement 17 in Figur 3 im Wesentlichen entspannt und in Figur 2 gespannt ist, so dass es bei Öffnen der Klappe 4 die Gelenkstange 12 aus der Rückzugsstellung 16 nach Figur 2 herausdrückt.

In Figur 4 ist ein weiteres Ausführungsbeispiel eines Gehäuses 1 mit Klappe 4 in Öffnungsstellung 7 dargestellt. Dieses Gehäuse 1 unterscheidet sich von dem Gehäuse nach Figur 1 darin, dass die entsprechenden Längsseiten 21, 22 länger als die Querseiten 23, 24 sind, so dass sich ein im Wesentlichen rechteckiger Querschnitt im Gegensatz zu den im Wesentlichen quadratischem Querschnitt nach Figur 1 ergibt. Ansonsten stimmen die übrigen Merkmale überein.

In der Öffnungsstellung 7 der Klappe 4 nach Figur 4 sind insbesondere die oberen Ende der Aufnahmebohrungen 29 in der Gehäusewandung 2 erkennbar. Im Bereich der Verbindungskanten 25 zwischen den verschiedenen Seiten sind in direkter Nachbarschaft zu diesen Aufnahmebohrungen 29 jeweils Aufnahmebohrung 13 für die verstellbare Lagerung der Gelenkstangen 12 angeordnet.

Die Klappe 4 ist in der Regel durch zwei solcher Gelenkstangen 12, siehe auch Figur 4, als Gelenkeinrichtung 6 gelagert, wobei auch eine andere Anordnung dieser Gelenkstangen beispielsweise in in Figur 4 vorderen Aufnahmebohrungen 13 möglich ist, sodass in diesem Fall die Klappe 4 in anderer Richtung zu Öffnen ist. Weiterhin besteht bei dem Gehäuse 1 nach Figur 4 die Möglichkeit, die entsprechenden Gelenkstangen 12 in den Aufnahmebohrungen 13 der Querseite 23 beziehungsweise der Querseite 24 verstellbar zu lagern, so dass in diesem Fall die Klappe 4 relativ zu einer Querseite zu Öffnen beziehungsweise zu Schließen wäre.

Erfindungsgemäß sind im Bereich aller Verbindungskanten 25 der entsprechenden Seiten die Ausnehmungen 18, 34 angeordnet, die auch nach Einbau eines entsprechenden Gehäuses 1 in einer anderen Einrichtung oder nach Anordnung eines weiteren Gehäuses 41 in direkter Nachbarschaft zum Gehäuse 1, siehe auch Figur 1, noch eine nachträgliche Montage der Klappe 4 mit beliebiger Öffnungsrichtung und beliebiger Lagerung relativ zu einer Seite ermöglichen.

Auf einer Klappenunterseite 10 ist in Figur 4 noch prinzipiell ein Dichtelement 35 dargestellt, welches beispielsweise eine Silikondichtung sein kann.

Entsprechende Dichtelemente 35 sind auch zwischen den Gehäuseeinzelteilen 26 und 27 anordbar, siehe hierzu auch Figur 1.

In Figur 4 sind insbesondere die Schraubbolzen 19 in Aufnahmebohrungen 29 sichtbar. Diese dienen gegebenenfalls zur Fixierung der Klappe 4 in Schließstellung 8.

Auf der Klappenunterseite 10 sind die entsprechenden Fortsetzungen der Aufnahmebohrungen 13 und 29 als Klappenbohrungen angeordnet, wobei diese in Verlängerung der Aufnahmebohrungen 13, im Wesentlichen als Einsteckvertiefungen ausgebildet und in diesen entsprechende Einsteckstutzen 30 angeordnet sind. Diese greifen bei Anordnung der Klappe 4 in Schließstellung 8 in die offenen Enden der Aufnahmebohrungen 13 entlang entsprechender Querseiten 23, 24 gegenüberliegend zu den Aufnahmebohrungen 13 zur verstellbaren Lagerung der Gelenkstangen 12 ein.

Auch diese Einsteckstutzen 30 sind bei anderer Lagerung der Klappe 4 in anderen Einsteckvertiefungen anordbar.

In Figur 5 ist eine perspektivische Ansicht auf zwei Gehäuse 1 und 41 dargestellt, die einen Querschnitt entsprechend zu dem Gehäuse 1 nach Figur 4 aufweisen. Allerdings sind die Klappen 4 nach Figur 5 entlang von Querseiten 23 und 24 verschwenkbar gelagert, siehe hierzu im Gegensatz die Lagerung der Klappe 4 entlang einer Längsseite 22 in Figur 4.

Im Übrigen entsprechen die Merkmale nach Figur 5 den bisher beschriebenen Merkmalen der anderen Gehäuse in den übrigen Figuren. In Figur 5 ist insbesondere noch erkennbar, dass in Öffnungsstellung 7 der Klappe 1 des Gehäuses 1 die Klappe 4 mit einer Querseite auf der Klappenoberseite 36 der Klappe 4 des Gehäuses 41 aufsteht. Zumindest bis zu diesem Ausmaß sind die Gelenkstangen 12 aus den entsprechenden Aufnahmebohrungen 13 herausziehbar. Es besteht die Möglichkeit, dass die Klappe 4 in der Öffnungsstellung 7 nach Figur 5 selbsttätig verbleibt, ohne dass sie von einer Bedienperson gehalten werden muss.

Analog zur Anordnung-der Gelenkstangen 12 sind in Figur 5 ebenfalls die entsprechenden Einsteckstutzen 30 entlang einer Querseite 24 angeordnet, siehe hierzu im Gegensatz Figur 4.

Erfindungsgemäß ergibt sich durch die Anordnung der Gelenkeinrichtung 6 im Wesentlichen innerhalb der Gelenkwandung 2, dass Gehäuse 1, 41, siehe beispielsweise Figuren 1 und 5, sehr eng benachbart zueinander anordbar sind, da keine externe Anordnung der Gelenkeinrichtung 6 erforderlich ist. Gleichzeitig wird der entsprechende Gehäuseinnenraum 44 in keiner Weise durch die Anordnung der Gelenkeinrichtung 6 verkleinert, so dass dieser für die Anordnung elektrischer oder elektronischer Komponenten vollständig nutzbar ist.

## Patentansprüche

1. Gehäuse (1), insbesondere explosionsgeschütztes Gehäuse, mit wenigstens einem eine Gehäusewandung (2) aufweisenden Gehäuseunterteil (3), welches eine durch eine Klappe (4) verschließbare Gehäuseöffnung (5) aufweist, wobei die Klappe (4) mittels einer Gelenkeinrichtung (6) zwischen einer Öffnungs- und einer Schließstellung (7, 8) verschwenkbar gelagert ist, wobei die Gelenkeinrichtung (6) ein in der Gehäusewandung (2) angeordnetes Gelenkunterteil (9) und ein an einer der Gehäuseöffnungen (5) in Schließstellung (8) zuweisenden Klappenunterseite (10) der Klappe (4) angeordnetes Oberteil (11) aufweist, welche verschwenkbar miteinander verbunden sind,
**dadurch gekennzeichnet,**
**dass** das Gelenkunterteil (9) in Schließstellung (8) zusammen mit dem Gelenkoberteil (11) in Wesentlichen innerhalb der Aufnahmebohrung (13) in Rückzugstellung (16) angeordnet ist.

2. Gehäuse nach Anspruch 1,
**dadurch gekennzeichnet,**
**dass** das Gelenkuhterteil (9) als Gelenkstange (12) ausgebildet ist, weiche zumindest teilweise in einer Aufnahmebohrung (13) in der Gehäusewandung (2) eingesteckt ist.

3. Gehäuse nach Anspruch 1 oder 2,
**dadurch gekennzeichnet,**
**dass** das Gelenkunterteil (9,12) in der Aufnahmebohrung (13) in Bohrungslängsrichtung (14) verschiebbar angeordnet ist.

4. Gehäuse nach einem der vorangehenden Ansprüche,
**dadurch gekennzeichnet,**
**dass** die Gelenkstange (12) an ihrem aus der Aufnahmebohrung (13) vorstehenden Gelenkende (15) mit dem Gelenkoberteil (11) verschwenkbar verbunden ist.

5. Gehäuse nach einem der vorangehenden Ansprüche,
**dadurch gekennzeichnet,**
**dass** die Gelenkstange (12) in Richtung Rückzugsstellung (16) kraftbeaufschlagt ist.

6. Gehäuse nach einem der vorangehenden Ansprüche,
**dadurch gekennzeichnet,**
**dass** ein Federelement (17) zur Kraftbeaufschlagung angeordnet ist.

7. Gehäuse nach Anspruch 6
**dadurch gekennzeichnet,**
**dass** das Federelement (17) an oder auf der Gelenkstange (12) angeordnet und zwischen dieser und einem Teil der Aufnahmebohrung (13) befestigt ist.

8. Gehäuse nach einem der vorangehenden Ansprüche,
**dadurch gekennzeichnet,**
**dass** die Aufnahmebohrung (13) zumindest eine im Wesentlichen quer zur Bohrungslängsrichtung (14) zur Außenseite (42) der Gehäusewandung (2) offene Ausnehmung (18, 34) aufweist.

9. Gehäuse nach einem der vorangehenden Ansprüche,
**dadurch gekennzeichnet,**
**dass** die Aufnahmebohrung (13, 29) zur Aufnahme eines Schraubbolzens (19) ausgebildet ist.

10. Gehäuse nach einem der vorangehenden Ansprüche,
**dadurch gekennzeichnet,**
**dass** eine Anzahl von Aufnahmebohrungen (13, 29) in Umfangsrichtung (20) des Gehäuses (1) in der Gehäusewandung (2) verteilt sind.

11. Gehäuse nach einem der vorangehenden Ansprüche,
**dadurch gekennzeichnet,**
**dass** das Gehäuse (1) einen insbesondere viereckigen Querschnitt mit zwei Längsseiten (21, 22) und zwei Querseiten (23, 24) aufweist und einige Aufnahmebohrungen (13, 29) im Wesentlichen entlang von Verbindungskanten (25) der Seiten (21, 24) in der Gehäusewandung (2) ausgebildet sind.

12. Gehäuse nach einem der vorangehenden Ansprüche,
**dadurch gekennzeichnet,**
**dass** das Federelement (17) als Schraubenfeder ausgebildet ist.

13. Gehäuse nach einem der vorangehenden Ansprüche,
**dadurch gekennzeichnet,**
**dass** das Gehäuseunterteil (3) aus mehreren Gehäuseeinzelteilen (26, 27) insbesondere mittels der Schraubbolzen (19) zusammengesetzt ist.

14. Gehäuse nach einem der vorangehenden Ansprüche,
**dadurch gekennzeichnet,**
**dass** die Klappenunterseite (10) Klappenbohrungen (28) insbesondere in Verteilung und Abmessung im Wesentlichen passend zu zumindest einigen der Aufnahmebohrungen (13, 29) aufweist.

15. Gehäuse nach einem der vorangehenden Ansprüche,
**dadurch gekennzeichnet,**
**dass** die Aufnahmebohrung (13) für die Gelenkstange (12) benachbart zur Aufnahmebohrung (29) für den Schraubbolzen (19) angeordnet ist und beide gemeinsame Ausnehmungen (18, 34) aufweisen.

16. Gehäuse nach einem der vorangehenden Ansprüche,
**dadurch gekennzeichnet,**
**dass** Einsteckstutzen (30) an der Klappenunterseite (10) entlang einer Seite (21 bis 24) gegenüberliegend zu den Gelenkoberteilen (11) angeordnet sind.

17. Gehäuse nach einem der vorangehenden Ansprüche,
**dadurch gekennzeichnet,**
**dass** das Federelement (17) mit einem Ende (31) an einem Aufnahmezwischenboden (33) zwischen zwei in Bohrungslängsrichtung (14) hintereinander ausgebildeten Ausnehmungen (18, 34) befestigt ist.

18. Gehäuse nach einem der vorangehenden Ansprüche,
**dadurch gekennzeichnet,**
**dass** die Aufnahmebohrung (13, 29) sich durch den Aufnahmezwischenboden (33) erstreckt.

19. Gehäuse nach einem der vorangehenden Ansprüche,
**dadurch gekennzeichnet,**
**dass** das Federelement (17) an einem unteren, in der Aufnahmebohrung (13) angeordneten Ende (43) der Gelenkstange (12) insbesondere lösbar befestigt ist.

20. Gehäuse nach einem der vorangehenden Ansprüche,
**dadurch gekennzeichnet,**
**dass** zwischen Gehäuseunterteil (3) und Klappe (4) Dichtelemente (35), insbesondere Silikondichtungen angeordnet sind.

21. Gehäuse nach einem der vorangehenden Ansprüche,
**dadurch gekennzeichnet,**
**dass** das Gehäuse (1) zur Wand-, Gitterrinnen- oder Rohrbefestigung ausgebildet ist.

22. Gehäuse nach einem der vorangehenden Ansprüche,
**dadurch gekennzeichnet,**
**dass** die Klappe (4) auf ihrer Oberseite (36) Griffmulden (37) und/oder Griffrillen (38) aufweist.

23. Gehäuse nach einem der vorangehenden Ansprüche,
**dadurch gekennzeichnet,**
**dass** die Aufnahme-/Klappenbohrung (13, 29) des Gehäuseunterteils (3) beziehungsweise der Klappe (4) an ihren jeweils zur Klappe beziehungsweise zum Gehäuseunterteil entfernten Enden (39) eine Versenkungsvertiefung (40) aufweisen.

24. Gehäuse nach einem der vorangehenden Ansprüche,
**dadurch gekennzeichnet,**
**dass** das Gehäuse (1) mit wenigstens einem weiteren Gehäuse (41) lösbar verbindbar ist.

## Claims

1. Housing (1), in particular an explosion-proof housing, comprising at least one lower housing part (3) which comprises a housing wall (2) and comprises a housing opening (5) which can be sealed by a hinged lid (4), the hinged lid (4) being mounted via an articulation means (6) so as to be pivotal between an open and a closed position (7, 8), the articulation means (6) comprising a lower articulation part (9), arranged in the housing wall (2), and an upper part (11), arranged on an underside (10) of the hinged lid (4) facing the housing openings (5) in the closed position (8), which are pivotally interconnected, **characterised in that** in the closed position (8), the lower articulation part (9) is arranged together with the upper articulation part (11) substantially inside the receiving hole (13) in the retracted position (16).

2. Housing according to claim 1, **characterised in that** the lower articulation part (9) is formed as an articulation rod (12), which is inserted into a receiving hole (13) in the housing wall (2) at least in part.

3. Housing according to either claim 1 or claim 2, **characterised in that** the lower articulation part (9, 12) is arranged in the receiving hole (13) so as to be displaceable in the longitudinal direction (14) of the hole.

4. Housing according to any one of the preceding claims, **characterised in that** the articulation end (15) of the articulation rod (12) projecting from the receiving hole (13) is pivotally connected to the upper articulation part (11).

5. Housing according to any one of the preceding claims, **characterised in that** a force is exerted on the articulation rod (12) towards the retracted position (16).

6. Housing according to any one of the preceding claims, **characterised in that** a spring member (17) is arranged to exert the force.

7. Housing according to claim 6, **characterised in that** the spring member (17) is arranged on the articulation rod (12) and fastened between said rod and a part of the receiving hole (13).

8. Housing according to any one of the preceding claims, **characterised in that** the receiving hole (13) comprises at least one recess (18, 34) which is open substantially transverse to the longitudinal direction (14) of the hole, towards the outer side (42) of the housing wall (2).

9. Housing according to any one of the preceding claims, **characterised in that** the receiving hole (13, 29) is formed to receive a stud (19).

10. Housing according to any one of the preceding claims, **characterised in that** a number of receiving holes (13, 29) are distributed in the housing wall (2) in the circumferential direction (20) of the housing (1)

11. Housing according to any one of the preceding claims, **characterised in that** the housing (1) has a cross-section, in particular a quadrilateral cross-section, having two longitudinal sides (21, 22) and two transverse sides (23, 24), and receiving holes (13, 29) are formed in the housing wall (2) substantially along connecting edges (25) of the sides (21, 24).

12. Housing according to any one of the preceding claims, **characterised in that** the spring member (17) is formed as a helical spring.

13. Housing according to any one of the preceding claims, **characterised in that** the lower housing part (3) is assembled from a plurality of individual housing parts (26, 27), in particular by means of the studs (19).

14. Housing according to any one of the preceding claims, **characterised in that** the underside (10) of the hinged lid comprises hinged lid holes (28), in particular corresponding substantially to at least some of the receiving holes (13, 29) in distribution and size.

15. Housing according to any one of the preceding claims, **characterised in that** the receiving hole (13) for the articulation rod (12) is arranged adjacent to the receiving hole (29) for the stud (19) and they both comprise common recesses (18, 34).

16. Housing according to any one of the preceding claims, **characterised in that** insertion connecting pieces (30) are arranged on the underside (10) of the hinged lid along a side (21 to 24) opposite the upper articulation parts (11).

17. Housing according to any one of the preceding claims, **characterised in that** one end (31) of the spring member (17) is fastened to an intermediate receiving base (33) between two recesses (18, 34) formed in succession in the longitudinal direction (14) of the hole.

18. Housing according to any one of the preceding claims, **characterised in that** the receiving hole (13, 29) extends through the intermediate receiving base (33).

19. Housing according to any one of the preceding claims, **characterised in that** the spring member (17) is connected, in particular releasably, to a lower end (43) of the articulation rod (12) arranged in the receiving hole (13).

20. Housing according to any one of the preceding claims, **characterised in that** sealing members (35), in particular silicone seals, are arranged between the lower housing part (3) and the hinged lid (4).

21. Housing according to any one of the preceding claims, **characterised in that** the housing (1) is formed for fastening to a wall, mesh cable tray or pipe.

22. Housing according to any one of the preceding claims, **characterised in that** the hinged lid (4) comprises recessed grips (37) and/or grip grooves (38) on the upper side (36) thereof.

23. Housing according to any one of the preceding claims, **characterised in that** the receiving hole and hinged lid hole (13, 29) of the lower housing part (3) and the hinged lid (4) respectively each comprise a counterbore (40) at the ends (39) thereof remote from the hinged lid and the lower housing part respectively.

24. Housing according to any one of the preceding claims, **characterised in that** the housing (1) is releasably connected to at least one further housing (41).

## Revendications

1. Boîtier (1), en particulier boîtier protégé contre les explosions, comprenant au moins une partie inférieure de boîtier (3) présentant une paroi de boîtier (2), qui présente une ouverture de boîtier (5) verrouillable par un volet (4), dans lequel le volet (4) est monté à pivotement au moyen d'un dispositif d'articulation (6) entre une position d'ouverture et une position de fermeture (7, 8), dans lequel le dispositif d'articulation (6) présente une partie inférieure d'articulation (9) agencée dans la paroi de boîtier (2) et une partie supérieure (11) agencée sur une face inférieure (10) du volet (4) affectée aux ouvertures de boîtier (5) en position de fermeture (8), qui sont raccordées l'une à l'autre à pivotement, **caractérisé en ce que**
la partie inférieure (9) de l'articulation en position de fermeture (8), conjointement avec la partie supérieure (11) de l'articulation, est agencée en position de retrait (16) sensiblement dans le perçage de réception (13).

2. Boîtier selon la revendication 1,
**caractérisé en ce que**
la partie inférieure (9) de l'articulation se présente sous la forme d'une barre d'articulation (12), qui est enfichée au moins partiellement dans un perçage de réception (13) dans la paroi de boîtier (2).

3. Boîtier selon la revendication 1 ou 2,
**caractérisé en ce que**
la partie inférieure (9, 12) de l'articulation est agencée à coulissement dans le perçage de réception (13) dans la direction longitudinale de perçage (14).

4. Boîtier selon l'une quelconque des revendications précédentes,
**caractérisé en ce que**
la barre d'articulation (12) est raccordée à pivotement, sur son extrémité d'articulation (15) faisant saillie du perçage de réception (13), avec la partie supérieure (11) de l'articulation.

5. Boîtier selon l'une quelconque des revendications précédentes,
**caractérisé en ce que**
la barre d'articulation (12) est soumise à une force en direction de la position de retrait (16).

6. Boîtier selon l'une quelconque des revendications précédentes,
**caractérisé en ce que**
un élément de ressort (17) est agencé pour l'application d'une force.

7. Boîtier selon la revendication 6,
**caractérisé en ce que**
l'élément de ressort (17) est agencé au niveau de la barre d'articulation (12) ou sur celle-ci et fixé entre celle-ci et une partie du perçage de réception (13).

8. Boîtier selon l'une quelconque des revendications précédentes,
**caractérisé en ce que**
le perçage de réception (13) présente au moins un évidement ouvert (18, 34) sensiblement transversalement à la direction longitudinale de perçage (14) par rapport au côté externe (42) de la paroi de boîtier (2).

9. Boîtier selon l'une quelconque des revendications précédentes,
**caractérisé en ce que**
le perçage de réception (13, 29) est conformé pour recevoir un boulon fileté (19).

10. Boîtier selon l'une quelconque des revendications précédentes,
**caractérisé en ce que**
il est réparti, dans la paroi de boîtier (2), un certain nombre de perçages de réception (13, 29) dans la direction périphérique (20) du boîtier (1).

11. Boîtier selon l'une quelconque des revendications précédentes,
**caractérisé en ce que**
le boîtier (1) présente une section transversale en particulier carrée ayant deux côtés longitudinaux (21, 22) et deux côtés transversaux (23, 24) et quelques perçages de réception (13, 29) sont formés sensiblement, dans la paroi de boîtier (2), le long d'arêtes de jonction (25) des côtés (21, 24).

12. Boîtier selon l'une quelconque des revendications précédentes,
**caractérisé en ce que**
l'élément de ressort (17) se présente sous la forme d'un ressort hélicoïdal.

13. Boîtier selon l'une quelconque des revendications précédentes,
**caractérisé en ce que**
la partie inférieure (3) du boîtier se compose de plusieurs parties individuelles de boîtier (26, 27) qui sont assemblées en particulier au moyen des boulons filetés (19).

14. Boîtier selon l'une quelconque des revendications précédentes,
**caractérisé en ce que**
la face inférieure (10) du volet présente des perçages de volet (28) en particulier dont la répartition et les dimensions correspondent sensiblement à au moins certains des perçages de réception (13, 29).

15. Boîtier selon l'une quelconque des revendications précédentes,
**caractérisé en ce que**
le perçage de réception (13) pour la barre d'articulation (12) est ménagé au voisinage du perçage de réception (29) pour le boulon fileté (19) et tous deux présentent des évidements communs (18, 34).

16. Boîtier selon l'une quelconque des revendications précédentes,
**caractérisé en ce que**
des tubulures d'enfichage (30) sont agencées sur la face inférieure de volet (10) le long d'un côté (21 à 24) en regard des parties supérieures (11) de l'articulation.

17. Boîtier selon l'une quelconque des revendications précédentes,
**caractérisé en ce que**
l'élément de ressort (17) est fixé sur une extrémité (31) à un fond intermédiaire de réception (33) entre deux évidements (18, 34) formés l'un derrière l'autre dans la direction longitudinale de perçage (14).

18. Boîtier selon l'une quelconque des revendications précédentes,
**caractérisé en ce que**
le perçage de réception (13, 29) traverse le fond intermédiaire de réception (33).

19. Boîtier selon l'une quelconque des revendications précédentes,
**caractérisé en ce que**
l'élément de ressort (17) est fixé en particulier de manière détachable sur une extrémité inférieure (43), agencée dans le perçage de réception (13), de la barre d'articulation (12).

20. Boîtier selon l'une quelconque des revendications précédentes,
**caractérisé en ce que**
des éléments d'étanchéité (35), en particulier des joints d'étanchéité en silicone, sont agencés entre la partie inférieure (3) du boîtier et le volet (4).

21. Boîtier selon l'une quelconque des revendications précédentes,
**caractérisé en ce que**
le boîtier (1) est conformé pour pouvoir être fixé au mur, à des chemins de câbles en fil ou des tuyaux.

22. Boîtier selon l'une quelconque des revendications précédentes,
**caractérisé en ce que**
le volet (4) présente sur sa face supérieure (36) des creux (37) et/ou des rainures (38) de prise.

23. Boîtier selon l'une quelconque des revendications précédentes,
**caractérisé en ce que**
le perçage de réception/du volet (13, 29) de la partie inférieure (3) du boîtier ou de la face inférieure du volet (4) présente une cavité de lamage (40) à ses extrémités (39) respectivement éloignées par rapport au volet ou à la partie inférieure de boîtier.

24. Boîtier selon l'une quelconque des revendications précédentes,
**caractérisé en ce que**
le boîtier (1) peut être raccordé de manière détachable à au moins un autre boîtier (41).
